# EUROPEAN PATENT SPECIFICATION

(11) **EP 1 482 317 B1**
(45) Date of publication and mention of the grant of the patent: **14.06.2006**
(21) Application number: 03380123.4
(22) Date of filing: 26.05.2003
(51) Int. Cl.: G01R 27/18

(54) **Earth resistance measurement instrument by neutral-to-earth loop and measurement procedure**
Vorrichtung zur Erdwiderstandsmessungen unter Verwendung der Neutral-Erde-Schleife und Messverfahren
Appareil pour mesurer la résistance à terre utilisant la boucle neutre-terre et procédé de mesure

(43) Date of publication of application: 01.12.2004
(73) Proprietor: Cirprotec, S.L., 08221 Terrassa (Barcelona) (ES)
(72) Inventor: Martin Peidro, Jose Antonio, 08221 Terrassa (Barcelona) (ES); Pons Gonzalez, Carlos, 08221 Terrassa (Barcelona) (ES)
(74) Representative: Esteban Perez-Serrano, Maria Isabel

(56) References cited:
- EP-A- 1 306 682
- WO-A-02/091003
- GB-A- 2 235 982
- GB-A- 2 241 843
- GB-A- 2 343 005
- US-A- 862 988
- US-A- 3 737 765
- US-A- 4 245 150

## Description

### OBJECT OF THE INVENTION

The present invention relates to an earth resistance measurement instrument by neutral-earth loop, permitting likewise measurement of the neutral impedance, as well as the procedure necessary for carrying out said measurement.

The present invention is characterised by the method for measuring the resistance of the earth conductor, which measurement is necessary to ensure that an earth fault provokes a homopolar current sufficient to activate the differential protection.

The equipment necessary to carry out the measurement of earth resistance and of neutral impedance can be installed in any part of the plant, on an electric panel for operation and control being preferable.

The system object of the invention is also characterised in that it includes the possibility of protection against overvoltages, as well as having a counter for these events, together with an alarm system, for the purpose of informing the user of the deficiency present in the facility.

### BACKGROUND OF THE INVENTION

Until the present time, the protective systems existing in interior electrical facilities are based on protection against overloads, employing for this electromagnetic circuit breakers, which protect against overloads occurring in a continuous manner or against high currents produced by a short circuit. All facilities must also have means of protection against leakage currents, the object being to prevent any metallic part of a plant becoming electrically live. This protection is implemented by means of differential circuit breakers.

Nevertheless, on few occasions is equipment conceived for knowing the value of the neutral impedance and the resistance of the earth circuit, values which are important for the purpose of avoiding that an earth fault provokes a homopolar current sufficient to activate differential protective devices, as laid down in the standard IEE 713-12 (earth fault loop impedance).

Equipment is known like that described in the patent EP 881500, wherein a procedure is disclosed for the measurement of the loop impedance of a supply network with neutral conductor through differential and magnetothermal relay. The procedure is based on a first measurement of the line resistance, based on the variation of potential with respect to earth, by injecting a current between line and neutral. Thereafter a current is injected below that of the differential protection between neutral and earth. In both cases a current is injected below that of differential protection.

In the patent EP 706663 a method is disclosed for measuring the loop impedance of an alternating current circuit protected with a circuit breaker which comprises the stages of injecting a current of value below that of tripping the circuit breaker in order that it flows in the loop, this method permitting detection and isolation of a voltage signal that is developed in the measuring process.

Finally loop testers are known such as those disclosed in the patent GB 2292225 which are based on the difference in the current flowing though one of the lines and that returning through the neutral, the tester being connected to whatever socket, employing the principle of measuring the voltage in open circuit and with a resistance connected between line and earth, which will be of sufficient size so that the voltage drop is not sufficiently high to provoke the tripping of the protective means.

In all the aforementioned patents importance is given to measuring the loop formed by a line and the earth, but in no case is a measurement obtained of both the neutral and earth resistance, nor do they incorporate a means of protection against overvoltages and a counter of transient overvoltage events. And finally, they lack any means for indicating the state of the facility, since they are no more than procedures or equipment for knowing the value at a given instant of the earthing resistance.

Furthermore, the procedures disclosed in the aforementioned patents, do not take into account the possible influence of the variation in the voltage measurement due to the evolution of the injected current wave.

Thus, the objective of the present invention is to overcome the preceding drawbacks developing for this a system of earth resistance measurement which permits the neutral impedance to be known, which has means of protection against overvoltages, and means for indicating a deficiency in the supply mains.

Finally it is also pointed out that an object of the present invention is to overcome the drawbacks arising from the measurement procedure through not taking into account the evolution of the injected waveform in the variation of the measured voltage.

It is known in the State of the art a circuit tester as the one disclosed in EP 1306682 used for among other functionalities for the measurement of the earth impedance through the injection of a current in the neutral-to-earth loop. This devices implies some drawbacks, as for example:
- the influence in the value of the voltage obtained of the noises present in the loop,
- the drift of the DC level injected,
- The values of the injected current are limited by tripping of Residual Current Device, or being necessary alternatively techniques of ramping,
- these devices require of energy dissipator implying a great final volume,
- there is an influence in the value obtained due to the evolution of the injected current, and
- it lacks of any protection means against transient overvoltages.

It is also known in the state of the art the document GB 2343005 where is disclosed an instrument for the measurement of earth loop resistance with out tripping Residual Current Detectors, based on the generation of a current immediately after the current has been passed from Phase to earth which is twice that the current for the same period, so the average current in the neutral line equates to that in the line over the whole measuring period.

So the aim of the present invention is to overcome the afore mentioned drawbacks designing a device for measuring the earth resistance by injected a current in the neutral-to-loop earth wherein there is not an influence of the noises present in the loop, neither of the drift of the injected current, where additionally there is not an influence of the value obtained due to the evolution of the injected current.

### DESCRIPTION OF THE INVENTION

The system of measurement of earth resistance by earth-to-neutral loop consists basically in an equipment which will be installed preferably on the general operation and control panel, being possible to install on the secondary panels, which is intended for mains protected by residual over-current or differential circuit breakers, single phase or three phase, equipped with neutral earth and protective earth conductor.

Said equipment will be governed by a microcontroller which comes with a liquid crystal display which will inform of the neutral and earth resistance measurements, as well as of the state of the installation.

The measurement of the neutral and earth resistance is based on the injection of a high peak current, generated through the discharge of a capacitor limited by a resistance. Said current is injected across the neutral conductor (N) and the protective conductor (PE), for a reduced time, the object being that the effective current integrated over one half-cycle is less than that which trips the differential protection. The measurements of the neutral and earth resistance are calculated from the measurement of the variations in neutral (N) and earth (PE) with respect to the line (L).

With the object of evaluating the variation in potential, different timing diagrams are employed:
- Measuring the voltage prior to application of the impulse and during the impulse, the application of the current impulse taking place close to 90°, so that all the variation in the voltage is due to the impulse and not to the evolution of the half-wave.
- Measurement of the voltage in application and non-application half-cycles of current, also at 90°, injecting the impulses in alternate half cycles, so that all the variation between half-cycles is due to the current injection.

The variation of the neutral voltage on the terminals of the equipment will appear as a negative pulse, and that of earth as a positive pulse, since the current is injected from neutral to earth.

Moreover, as well as the measurements of earth and neutral resistance, the equipment carries out a periodic check of the installation making use of the values measured and the waveform, providing voltage values, of inversion of the line-to-earth, line-to-neutral connections, it being possible to indicate from the readings obtained the presence of the neutral in open circuit and of the earth.

The equipment also allows protection against overvoltages employing for this an overvoltage limiting device between line and neutral and between neutral and earth. The protection is of the type zinc-oxide varistor, gas arrester or a combination of the two.

Additionally it has a counter of transient overvoltages, which permits the number of times to be known that the earth voltage or the line voltages surpassed the limit for actuation of the protection, within a preestablished period.

Finally the equipment has an alarm for alerting an abnormality (very high neutral or earth resistance, voltage out of range, high number of overvoltages), activating in the event an output of the equipment which closes a contact that operates an alarm.

All the equipment comes with means for assembly on normalised DIN rails, capable of being plugged into earth sockets already existing.

### DESCRIPTION OF THE DRAWINGS

To complete the description that is being made and with the object of assisting in a better understanding of the characteristics of the invention, attached to the present descriptive specification, as an integral part thereof, is a set of drawings wherein by way of illustration and not restrictively, the most significant features of the invention have been represented:

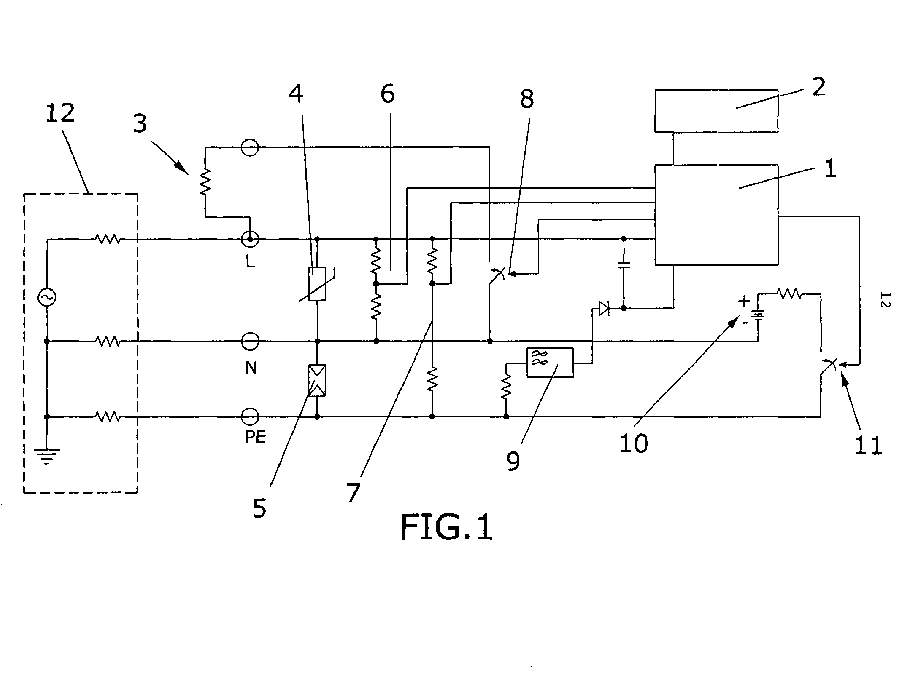

Figure 1 shows the schematic of the equipment for measuring earth resistance by neutral-to-earth loop.

### PREFERRED EMBODIMENT OF THE INVENTION

In the light of the aforementioned figures, a preferred mode of embodiment of the proposed invention is described below.

In figure 1 the equipment object of the invention can be seen, which comes with a microcontroller (1) which serves to govern and control the assembly, to which is connected a liquid crystal display LCD (2) which informs of the transient overvoltages occurred in the earth resistance, on the state of the transient protection, on the state of the facility and of the network.

The equipment is connected through some terminal posts to the line conductor L, the neutral N, and that of protection PE, which proceed from a generating facility (12), having the characteristic that both the generating facility and the protective conductor are earthed either in the same place or separately, in this manner it is possible to carry out the measurement of the neutral and earth resistance through the earth / neutral loop.

A varistor (4) is likewise observed mounted between line and neutral, as well as a gas discharge tube (5), both serving for protection against overvoltages.

Thanks to the voltage dividers (6) and (7) the value of the voltage between line and neutral is known, as well as between line and earth when a current signal has been injected.

To know the number of overvoltages which occur in the installation, use is made of a filter (9) which permits said incidents to be detected.

Said current signal is injected on closing the contact (11) governed by the microcontroller (1). The power necessary for injecting the signal proceeds from a battery (10).

Finally there is a contactor (8) which, once closed, permits the supply of current to an alarm (3) serving to alert of the different situation of "abnormality'' (very high neutral or earth resistance, voltage out of range, high number of overvoltages, etc.).

It is not considered necessary to extend this description further for an expert in the matter to comprehend the scope of the invention and the benefits which derive therefrom.

The materials, form, size and arrangement of the elements will be capable of variation provided they do not alter the essential nature of the invention.

The terms in which this specification has been written are to be taken always in their broadest sense and never restrictively.

## Claims

1. - Equipment for measuring earth resistance by means of a neutral-to-earth loop for AC power supply networks with differential or residual overcurrent circuit breakers, single phase or three phase, with earthed neutral conductor (N) and with protective earth conductor (PE) having means for the injection of a current into the neutral-to-earth loop, means for protection against overvoltages integrated in the equipment and including differential or residual circuit breakers **characterized in that:**
- the means for the injection of a current into the neutral-to-earth loop produce a high peak current of short duration which is generated through the discharge of a capacitor limited by a resistance and injected across the earthed neutral conductor (N) and the protective eath conductor (PE) so that the effective current integrated over a half-cycle is less than that which trips the differential or residual circuit breakers, the injection being carried out close to 90° of the AC power supply voltage, so that all the variation in the voltage is due to the high peak current of short duration and not to the evolution of the half-wave of the AC power supply network, wherein the measurements of the neutral and earth resistance are obtained from the measurement of the variations of the earthed neutral conductor (N) and the protective earth conductor (PE) potential with respect to the line conductor (L) and the value of the injected current,
- it comprises indicative means (2) and/or alarm (8).

2. - Equipment for measuring earth resistance by means of the neutral-to-earth loop according to claim 1, **characterized in that** the means for protection against overvoltages are zinc oxide varistors (4) or gas discharge tubes (5).

3. - Equipment for measuring earth resistance by means of neutral-to-earth loop according to claim 1, **characterized in that** the equipment carries out a periodic check of the AC power supply network making use of the values measured and the AC power supply network waveform, wherein the equipment also includes indicative means which provide information of high neutral or earth resistance or voltage out of range or high number of transient overvoltages or similar events, and it is also provided with means (8) capable of operating a remote alarm (3) placed externally to the equipment, being used to alert of the different situations.

4. - Equipment for measuring earth resistance by means of the neutral-to-earth loop according to claim 1, **characterized in that** it is mounted on the distribution panels on a normalized DIN rail.

5. - Procedure for the measurement of earth resistance by the neutral-to-earth loop in the equipment of claim 1, **characterized in that** it comprises the following steps:
- injection of a current into the neutral-to-earth loop produce a high peak current of short duration, which is generated through the discharge of a capacitor limited by a resistance and injected across the earthed neutral conductor (N) and the protective earth conductor (PE) so that the effective current integrated over a half-cycle of the AC power supply network is less than that which trips the differential or residual circuit breakers, said injection being carried out close to 90° of the AC power supply voltage, obtaining thereafter the measurement of the neutral and earth resistance from the measurement of the variations of the earthed neutral conductor (N) and protective earth conductor (PE) potential with respect to the line conductor (L),
- protection against overvoltages,
- counting transient overvoltages, and
- measurement of earth resistance.

6. - Procedure for the measurement of earth resistance by the neutral-to-earth loop according to claim 5, **characterized in that** with the object of evaluating the variation in potential use is made of the voltage measurement prior to application of the high peak current of short duration and during its application, being carried out the application close to 90° of the AC power supply, so that all the variation in the voltage is due to the high peak current of short duration and not to the evolution of the half-wave of the AC power supply network.

7. - Procedure for the measurement of earth resistance by neutral-to-earth loop according to claim 5, **characterized in that** with the object of evaluating the variation in potential use is made of the measurement of the voltage in application and non-application half-cycles of current, also at 90°of the AC power supply, injecting the high peak current of short duration in alternate cycles, so that the variation between half-cycles of the AC power supply network is due to the current injection.

## Patentansprüche

1. Gerät zum Messen des Erdungswiderstands mittels eines Stromkreises Neutral an Erdung für Wechselstromenergieversorgungsnetze mit differenzialen oder remanenten Überstromabschaltern, einphasig oder dreiphasig, mit geerdetem neutralem Leiter (N) und mit Schutzerdungsleiter (PE), ausgestattet mit Vorrichtungen für die Einspeisung von Strom in den Stromkreis Neutral an Erdung, Vorrichtungen zum Schutz gegen Überspannungen integriert in das Gerät und mit differenzialen oder remanenten Überstromabschaltern, **dadurch gekennzeichnet, dass**:
- die Vorrichtungen zur Einspeisung von Strom in den Stromkreis Neutral an Erdung eine Höchststrom von kurzer Dauer erzeugt, der durch die Entladung eines Kondensators verursacht wird, der durch einen Widerstand begrenzt ist und über den geerdeten neutralen Leiter (N) und den Schutzerdungsleiter (PE) eingespeist wird, so dass der effektive Strom innerhalb einer Halbwelle geringer ist als der, der die differenzialen oder remanenten Abschalter auslöst, wobei die Einspeisung nahe 90° zu der Wechselstromversorgungsspannung durchgeführt wird, so dass alle Abweichungen der Spannung auf Grund des Höchststroms von kurzer Dauer entstehen und nicht auf Grund der Entwicklung der Halbwelle des Wechselstromenergieversorgungsnetzes entstehen, wobei man die Messung des neutralen Widerstands und des Erdungswiderstands von der Messung der Abweichungen des Potenzials des geerdeten neutralen Leiters (N) und des Schutzerdungsleiters (PE) erhält hinsichtlich der Leitung (L) und des Werts des eingespeisten Stroms.
- sie Anzeige (2)- und/oder Alarmvorrichtungen (8) umfasst.

2. Gerät zum Messen des Erdungswiderstands mittels eines Stromkreises Neutral an Erdung gemäss Anspruch 1, **dadurch gekennzeichnet, dass** die Mittel zum Schutz gegen Überspannungen Zinkoxidvaristoren (4) oder Gasentladungsrohre (5) sind.

3. Gerät zum Messen des Erdungswiderstands mittels eines Stromkreises Neutral an Erdung gemäss Anspruch 1, **dadurch gekennzeichnet, dass** die Vorrichtung regelmässige Überprüfungen des Wechselstromenergieversorgungsnetzes durchführt, wofür die gemessenen Werte und die Wellenform des Wechselstromenergieversorgungsnetzes verwendet werden, wobei das Gerät auch Anzeigemittel umfasst, die Information über einen hohen neutralen oder geerdeten Widerstand oder Spannung ausserhalb des Bereichs oder gehäufte Übernahmehochspannungen oder ähnliche Vorkommnisse gibt und ausserdem mit Mitteln (8) ausgestattet ist, die in der Lage sind, eine Fernalarmvorrichtung (3) auszulösen, die sich ausserhalb des Geräts befindet und verwendet wird, um bei den unterschiedlichen Situationen zu warnen.

4. Gerät zum Messen des Erdungswiderstands mittels eines Stromkreises Neutral an Erdung gemäss Anspruch 1, **dadurch gekennzeichnet, dass** es auf der Verteilungsanlage auf einer genormten DIN-Führung installiert ist.

5. Verfahren zum Messen des Erdungswiderstands mittels eines Stromkreises Neutral an Erdung in dem Gerät des Anspruchs 1, **dadurch gekennzeichnet, dass** es die folgenden Schritte umfasst:
- Einspeisung eines Stroms in den Stromkreis, wodurch ein Höchststrom von kurzer Dauer erzeugt wird, der durch die Entladung eines Kondensators verursacht wird, der durch einen Widerstand begrenzt ist und über den geerdeten neutralen Leiter (N) und den Schutzerdungsleiter (PE) eingespeist wird, so dass der effektive Strom innerhalb einer Halbwelle des Wechselstromenergieversorgungsnetzes geringer ist als der, der die differenzialen oder remanenten Abschalter auslöst, wobei die besagte Einspeisung nahe 90° zu der Wechselstromversorgungsspannung durchgeführt wird, wonach man die Messung des neutralen Widerstands und des Erdungswiderstands von der Messung der Abweichungen des Potenzials des geerdeten neutralen Leiters (N) und des Schutzerdungsleiters (PE) erhält hinsichtlich der Leitung (L).
- Schutz gegen Überspannungen,
- Zählung von Übernahmehochspannungen
- Messung des Erdungswiderstands.

6. Verfahren zum Messen des Erdungswiderstands mittels eines Stromkreises Neutral an Erdung gemäss Anspruch 5, **dadurch gekennzeichnet, dass** mit dem Zweck der Bewertung der Abweichungen im Potenzial die Spannungsmessung verwendet wird, bevor der Höchststrom von kurzer Dauer angewendet wird und für den Zeitraum der Anwendung, wobei die wobei die Einspeisung nahe 90° zu der Wechselstromversorgungsspannung durchgeführt wird, so dass alle Abweichungen der Spannung auf Grund des Höchststroms von kurzer Dauer entstehen und nicht auf Grund der Entwicklung der Halbwelle des Wechselstromenergieversorgungsnetzes entstehen.

7. Verfahren zum Messen des Erdungswiderstands mittels eines Stromkreises Neutral an Erdung gemäss Anspruch 5, **dadurch gekennzeichnet, dass** mit dem Zweck der Bewertung der Abweichungen im Potenzial die Spannungsmessung verwendet wird, in Stromhalbwellen der Anwendung oder Nicht-Anwendung, auch bei 90° zu der Wechselstromversorgungsspannung, wobei der Höchststrom von kurzer Dauer in alternierenden Zyklen eingespeist wird, so dass die Abweichung zwischen den Halbwellen des Wechselstromsversorgungsnetzes auf Grund der jeweiligen Einspeisung zustande kommt.

## Revendications

1. Equipement pour mesurer la résistance de terre au moyen d'une boucle de neutre à terre pour des réseaux d'alimentation de CA avec des courts-circuits de surintensités différentielles ou résiduaires, monophasés ou triphasés, avec un conducteur (N) neutre lié à terre et avec un conducteur (PE) de terre protecteur ayant des moyens pour l'injection d'un courant dans la boucle de neutre à terre, des moyens pour la protection contre des surintensités intégrées dans l'équipement et qui inclut des courts-circuits différentiels o résiduaires, **caractérisé en ce que**
- les moyens pour l'injection d'un courant dans la boucle de neutre à terre produisent un courant de crête élevée de courte durée qui est générée à travers la décharge d'un condensateur limité par une résistance et injectée à travers le conducteur (N) neutre lié à terre et le conducteur (PE) de terre protecteur de manière que le courant effectif intégré pendant un demi-cycle est inférieur à celui qui active les courts-circuits différentiels ou résiduaires, l'injection ayant lieu à environ 90° de la tension d'alimentation de CA, de manière que toute la variation dans la tension est due au courant de crête élevé de courte durée et non pas à l'évolution de la demi-onde du réseau d'alimentation de CA, dans laquelle les mesures des variations du conducteur (N) neutre lié à terre et le potentiel du conducteur (PE) de terre protecteur par rapport au conducteur (L) de ligne et la valeur du courant protecteur injecté,
- il comprend des moyens (2) indicatifs et/ou des moyens (8) d'alarme.

2. Equipement pour mesurer la résistance de terre au moyen de la boucle de neutre à terre selon la revendication 1, **caractérisé en ce que** les moyens pour la protection contre les surtensions sont des varistors (4) d'oxyde de zinc ou des tubes (5) de décharge de gaz.

3. Equipement pour mesurer la résistance de terre au moyen de la boucle de neutre à terre selon la revendication 1, **caractérisé en ce que** l'équipement accomplit une vérification périodique du réseau d'alimentation de CA en utilisant les valeurs mesurées et la forme d'onde du réseau d'alimentation de CA, dans lequel l'équipement inclut également des moyens qui fournissent de l'information sur la résistance élevée de neutre ou de terre ou la tension hors-rang ou le nombre élevé de surtensions transitoires ou des événements similaires, et il est également pourvu de moyens (8) aptes à activer une alarme (3) distante disposée extérieurement à l'équipement, celle-ci étant utilisée pour alerter de situations différentes.

4. Equipement pour mesurer la résistance de terre au moyen de la boucle de neutre à terre selon la revendication 1, **caractérisé en ce qu'**il est monté sur les panneaux de distribution sur un rail DIN normalisé.

5. Procédé pour mesurer la résistance de terre par la boucle de neutre à terre dans l'équipement de la revendication 1, **caractérisé en ce qu'**il comprend les étapes suivantes:
- l'injection d'un courant dans la boucle de neutre à terre produit un courant de crête élevée de courte durée, lequel est généré à travers la décharge d'un condensateur limité par une résistance et injecté à travers le conducteur (N) neutre lié à terre et le conducteur (PE) de terre protecteur de manière que le courant effectif intégré pendant un demi-cycle dans le réseau d'alimentation de CA est inférieur à celui qui active les courts-circuits différentiels ou résiduaires, ladite injection étant accomplit environ à 90° de la tension d'alimentation de CA, en obtenant par la suite les mesures de la résistance de neutre et de terre à partir de la mesure des variations du conducteur (N) neutre lié à terre et le potentiel du conducteur (PE) de terre protecteur par rapport au conducteur (L) de ligne
- protection contre les surtensions,
- comptage de tensions transitoires, et
- mesure de résistance de terre.

6. Procédé pour mesurer la résistance de terre par la boucle de neutre à terre selon la revendication 5 5, **caractérisé en ce que** l'objet de l'évaluation de la variation dans l'utilisation de potentiel est réalisé au moyen de la mesure de tension avant l'application du courant de crête élevé de courte durée et pendant son application, l'application étant réalisée à environ 90° de la source d'alimentation de CA, de manière que toute la variation dans la tension est due au courant de crête élevée de courte durée et non pas à l'évolution de la demi-onde du réseau d'alimentation de CA.

7. Procédé pour mesurer la résistance de terre par la boucle de neutre à terre selon la revendication 5, **caractérisé en ce que** l'objet de l'évaluation de la variation dans l'utilisation de potentiel est réalisé au moyen de la mesure de la tension en demi-cycles d'application et non-application, également à 90° de la source d'alimentation de CA, en injectant le courant de crête élevée de courte durée dans des cycles alternés, de manière que la variation entre les demi-cycles dans le réseau d'alimentation de CA est due à l'injection de courant.
